## Europäisches Patentamt

## European Patent Office

## Office européen des brevets

(19)

(11) Numéro de publication: **0 027 761**
**B1**

(12) **FASCICULE DE BREVET EUROPEEN**

(45) Date de publication du fascicule du brevet: **09.05.84**

(21) Numéro de dépôt: **80401467.8**

(22) Date de dépôt: **14.10.80**

(51) Int. Cl.³: **H 01 L 29/80,**
**H 01 L 29/62,**
**H 01 L 29/205**

(54) Dispositif semiconducteur à effet de champ pour hautes fréquences et transistor utilisant un tel dispositif semiconducteur.

(30) Priorité: **26.10.79 FR 7926611**

(43) Date de publication de la demande:
**29.04.81 Bulletin 81/17**

(45) Mention de la délivrance du brevet:
**09.05.84 Bulletin 84/19**

(84) Etats contractants désignés:
**DE GB IT NL**

(56) Documents cités:
**EP - A - 0 017 531**
**US - A - 4 065 781**
**US - A - 4 075 652**
**US - A - 4 160 261**

**ELECTRONICS LETTERS, vol. 13, no. 24,**
**novembre 1977 Hitchin GB H. MORKOC et al.:**
**"Normally-off A10,5Ga0,5 As heterojunction-**
**gate GaAs FET, pages 747-748**

**SOLID-STATE TECHNOLOGY, vol. 21, no. 12,**
**décembre 1978 Washington US S. MARSHALL:**
**"Advances of GaAs CCDs and MOSFETS", page**
**45**

(73) Titulaire: **THOMSON-CSF**
**173, Boulevard Haussmann**
**F-75379 Paris Cedex 08 (FR)**

(72) Inventeur: **Nuyen, Trong Linh**
**"THOMSON-CSF" SCPI 173, Bld Haussmann**
**F-75360 Paris Cedex 08 (FR)**
Inventeur: **Delagebeaudeuf, Daniel**
**"THOMSON-CSF" SCPI 173, Bld Haussmann**
**F-75360 Paris Cedex 08 (FR)**

(74) Mandataire: **Taboureau, James et al,**
**THOMSON-CSF SCPI 173, Bld Haussmann**
**F-75379 Paris Cedex 08 (FR)**

# Description

La présente invention concerne des perfectionnements aux dispositifs semiconducteurs de type transistor à effet de champ et plus spécialement ceux dont la fréquence de coupure est élevée.

On connait un transistor à effet de champ, décrit dans la demande de brevet euro-péen EP—A—0 017 531, au nom de la demanderesse comportant un substrat semi-isolant, des régions source et drain, une couche active en GaAs et une grille formant avec la couche active une hétérojonction isotype n-n. La grille, en n-Al$_x$Ga$_{1-x}$As de faible épaisseur, peut être recouverte d'une couche d'isolant pour diminuer le courant de fuite à travers la grille.

Ce type de semiconducteur constitue un progrès important dans le sens de l'augmentation des fréquences de coupure des transistors à effet de champ mais il présente néanmoins deux limitations: son impédance de sortie, et son mode de fonctionnement, "normalement passant."

En premier lieu, la couche active en GaAs est constituée par deux régions: l'une qui est la région d'accumulation des électrons, l'autre qui occupe la plus grande partie de l'épaisseur de la couche de GaAs. Cette seconde région peu dopée se comporte comme une résistance connectée en parallèle avec celle constituée par la zone d'accumulation: l'ensemble de ces deux résistances en parallèle constitue une faible résistance de sortie.

En second lieu, ce type de transistor est en position "normalement passante", c'est-à-dire qu'en l'absence de toute polarisation de la grille de commande, un courant passe entre la source et le drain, lorsque le drain est polarisé par rapport à la source: que le transistor soit conducteur en l'absence d'une tension de commande peut-être gênant dans certaines applications.

Le type de transistor à effet de champ, à hétérojonction, selon l'invention, a une fréquence de coupure de l'ordre de 30% supérieure à celle des transistors MES-FET. Ceci est dû aux propriétés particulières de l'hétéro-jonction GaAs/Al$_x$Ga$_{1-x}$As.

A la différence du couple de matériaux Ga/GaAs où des difficultés d'ordre technologique et peut être de physique, font que l'interface est de qualité médiocre et porteur d'une charge négative fixe importante, le couple GaAs/Al$_x$Ga$_{1-x}$As semble se comporter de façon quasi idéale. La présence d'éventuels pièges ou centres de recombinaison à l'interface n'a pu être révélée et la transition peut être très abrupte. L'hétérojonction satisfait alors au modèle proposé par Anderson dans un article intitulé "germanium gallium arsenide hétérojonctions" (IBM journal, juillet 1960, pages 283—287). Cette propriété a été vérifiée par DINGLE et ses collaborateurs dans un article intitulé "Electron mobilities in modulation doped semiconductor, hetero-jonction superlattice" [App. Phys. Lett vol 33, n° 7, p. 665 (1978)], sur une structure "super-réseau" constituée par un empilement régulier de couches alternatives de GaAs non intentionnellement dopé et de Al$_x$Ga$_{1-x}$As dopé n. Dans le cas d'une hétérojonction isotype n GaAs n (peu dopé)/n Al$_x$Ga$_{1-x}$As:

— la transition peut être très abrupte;

— l'interface est quasi idéale; peu de pièges, de centres de recombinaison, de charge fixe;

— il existe une couche électronique d'accumulation dans le matériau GaAs résultant de la séparation spatiale des porteurs par rapport aux impurités qui les fournissent et qui sont incorporées dans la couche de Ga$_{1-x}$Al$_x$A$_s$ fortement dopée par rapport à la couche de GaAs;

— la mobilité dans la couche d'accumulation est proche de la mobilité en volume du matériau la supportant (GaAs) et donc n'est pas dégradée par le voisinage de l'interface.

Cette propriété de mobilité électronique a été appliquée par DINGLE et ses collaborateurs dans un transistor du type à grille Schottky à hétérojonction isotype n-Al$_x$Ga$_{1-x}$As/n-GaAs où une telle série de minces couches sont alternativement disposées pour former la zone active ce transistor faisant l'objet d'une demande de brevet EP—A—0 005 059.

L'objet de la présente invention est d'une part, d'accroître la résistance de sortie du transistor, et d'autre part de le rendre "normalement bloqué", c'est-à-dire, qu'il ne laisse pas passer le courant lorsque la grille n'est pas polarisée. Ces deux objectifs sont simultanément atteints par l'utilisation d'une couche en GaAs de type p faiblement dopée, à la place de celle en GaAs de type n précédemment décrite. L'hétérojonction utilisée est donc anisotype p-n p GaAs/n Al$_x$Ga$_{1-x}$As. Le transport de courant n'est plus assuré par une zone d'accumulation d'électrons comme dans le cas du transistor à canal n-GaAs et grille n-Ga$_{1-x}$Al$_x$As tel que décrit dans EP—A—0 017 531 mais par une zone d'inversion de charges ainsi qu'il va être montré ci-dessous.

De façon plus précise, l'invention consiste en un transistor à effet de champ pour hautes fréquences, du type normalement bloqué, a résistance de sortie élevée comportant, supportée par un substrat semi-isolant, une région de commande constituée d'une couche active et d'une couche de grille formant une hétérojonction, ce dispositif étant caractérisé, en ce que l'hétérojonction est formée d'une couche active en GaAs faiblement dopé de type p et d'une couche faisant fonction de grille de com-mande en Al$_x$Ga$_{1-x}$As dopé de type n, une zone d'inversion de charge à grande mobilité électronique se formant dans la couche active de type p, à proximité de l'hétérojonction lorsqu'une tension positive est appliquée sur la

grille en $Al_xGa_{1-x}As$ et n'existant pas en l'absence de cette polarisation.

L'invention sera mieux comprise grâce aux explications qui suivent, lesquelles s'appuient d'une part sur des exemples de réalisations de transistors, et d'autre part sur les figures qui représentent:

— figure 1: coupe d'un transistor FET à l'hétérojonction isotype n-n selon l'art antérieur.

— figures 2 et 3: schéma de bandes d'une hétérojonction isotype n-n pour des polarisations de grille nulle et positive.

— figures 4 et 5: schéma de bandes d'une hétérojonction anisotype p GaAs/n $Al_x Ga_{1-x} As$ pour des polarisations de grille nulle et positive.

— figure 6: coupe d'un transistor FET à hétérojonction anisotype p GaAs/n $Al_xGa_{1-x}As$ selon l'invention.

— figure 7: coupe d'un transistor FET selon l'invention, dans une autre forme de réalisation.

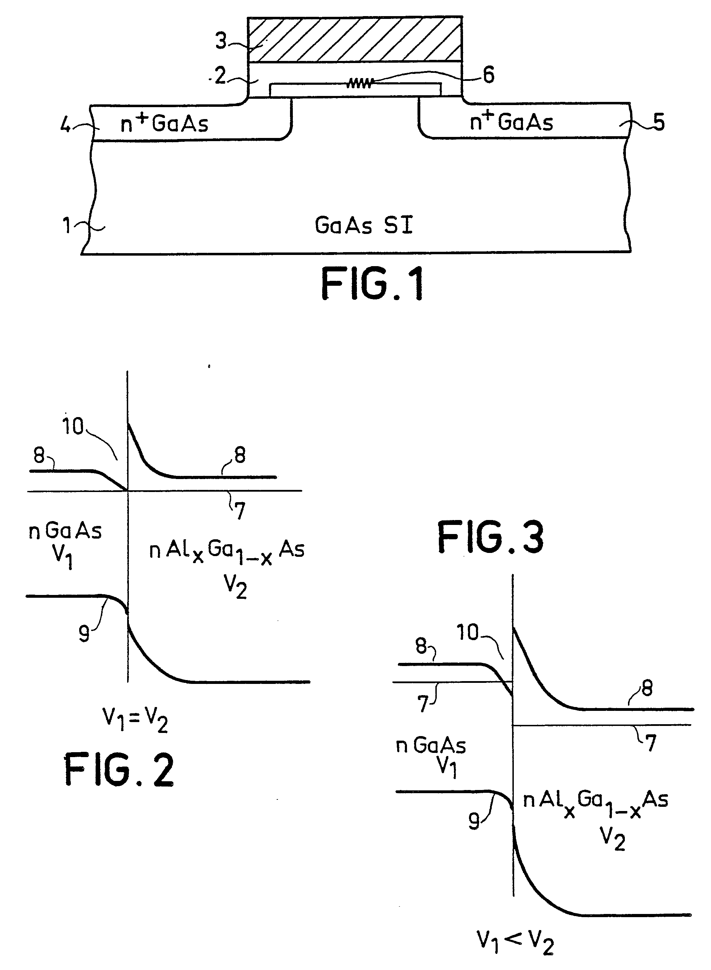

La figure 1 montre la structure d'un transistor à hétérojonction isotype n-n, selon l'art antérieur, Il comporte un substrat semi-isolant 1, en arséniure de gallium GaAs sur lequel est réalisée une couche active 2, en GaAs faiblement dopé de type n, qui support une grille de commande 3, en $Al_xGa_{1-x}As$ de type n. Les régions $n^+$ de source 4 et de drain 5 sont diffusées ou implantées dans le substrat en GaAs. La résistance de sortie 6, entre source et drain, est relativement faible puis qu'elle est constituée de la mise en parallèle de la résistance de la zone d'accumulation et de celle de la couche active restante.

Les figures 2 et 3 montrent les schémas de bandes d'une hétérojonction GaAs type n-$Al_x Ga_{1-x} As$ de type n. La couche de GaAs est à un potentiel $V_1$ et la couche de $Al_xGa_{1-x}As$ à un potentiel $V_2$. Le niveau de Fermi est représenté par la droite 7, la bande de conduction par la couche 8 et la bande de valence par la courbe 9. Dans la figure 2, où les deux matériaux sont au même potentiel $V_1 = V_2$, les courbures de bande sont telles qu'il apparaît du côté GaAs une zone d'accumulation d'électrons 10 à l'interface de l'hétérojonction. Dans la figure 3 où $Al_x Ga_{1-x} As$ est polarisé positivement par rapport à GaAs, $V_2 > V_1$, cette zone d'accumulation d'électrons 10 est fortement prononcée. Ces deux figures 2 et 3 qui montrent le diagramme de bandes d'une hétérojonction isotype n-n permettent de mieux comprendre le fonctionnement du transistor FET à hétérojonction anisotype p-n à inversion de charges, objet de la présente invention.

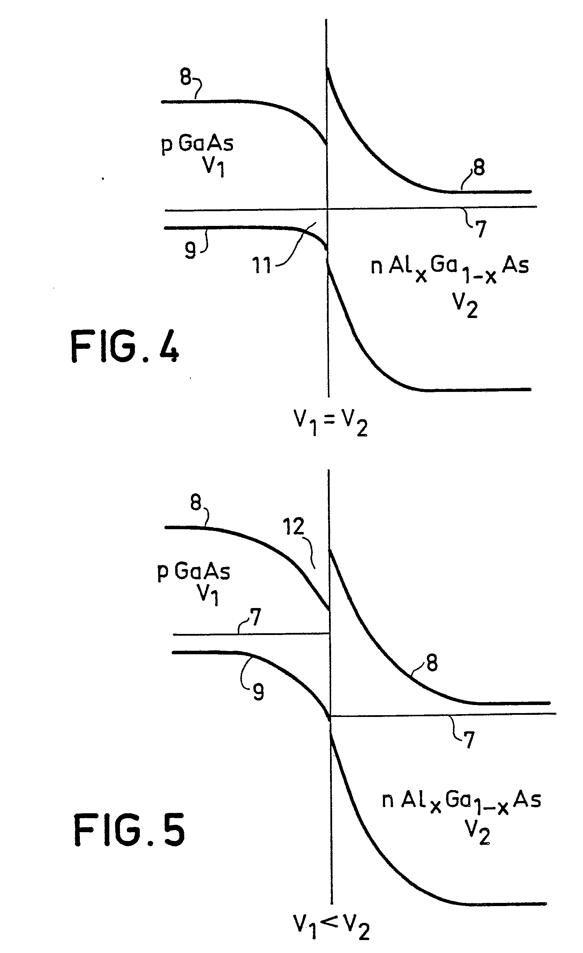

Les figures 4 et 5 représentent les schémas de bandes d'une hétérojonction anisotype GaAs type p-$Al_x Ga_{1-x} As$ type n selon le modèle d'Anderson. Les mêmes indices de repère identifient les mêmes éléments que sur les figures 2 et 3. Dans la figure 4, où les deux matériaux sont au même potentiel $V_1 = V_2$, les courbures de bandes font apparaître une zone dépeuplée de trous 11. Lorsque $Al_x Ga_{1-x} As$ est polarisé positivement par rapport à GaAs, —

figure 5 — le dépleuplement des trous s'accentue et si la tension de polarisation est suffisamment forte, la concentration de trous devient plus faible que la concentration d'électrons: par suite, il existe à l'interface de l'hétérojonction une couche de type n dans GaAs initialement dopé p. Cette couche est appelée couche d'inversion de charges ou plus simplement couche d'inversion 12. D'une manière analogue aux couches d'accumulation existant dans les hétérojonctions isotype n-n, les couches d'inversion présentent une forte mobilité d'électrons si le matériau GaAs de type p contient peu d'impuretés c'est-à-dire est faiblement dopé p.

Etant donné que le courant source-drain est assuré à travers la couche d'inversion, en l'absence de polarisation grille, positive la couche d'inversion n'existant pas, le courant source-drain est nécessairement nul: le transistor fonctionne donc en mode normalement bloqué et la résistance de sortie du transistor est plus élevée que dans le cas de l'hétérojonction isotype n-n.

Cependant, un phénomène de fuite de courant peut se produire entre la couche d'inversion du côté GaAs et $Al_x Ga_{1-x}$ As. Le courant de fuite dans ce cas d'hétérojonction anisotype p-n est évité de même que dans le cas des hétérojonctions isotypes où existe une couche d'accumulation par l'interposition d'un isolant entre la grille de $Al_x Ga_{1-x}$ As et la métallisation de grille.

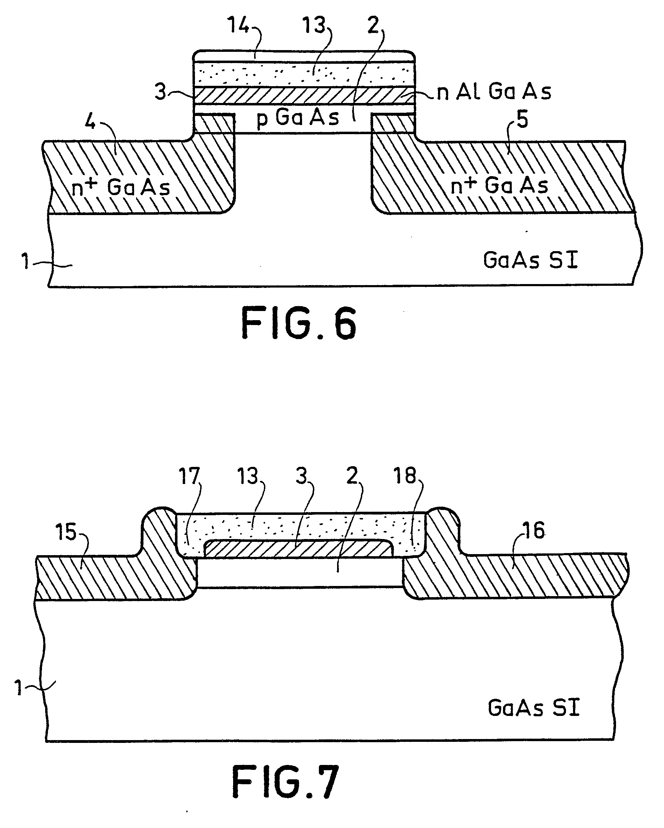

La figure 6 montre, vu en coupe, un premier exemple de réalisation de transistor selon l'invention, qui tient compte des moyens énoncés pour augmenter la résistance de sortie et supprimer les courants de fuite.

Le transistor FET à hétérojonction anisotype p-n, schématisé sur la figure 6, comporte un substrat en GaAs semi-isolant 1, une couche active 2 en GaAs faiblement dopé de type p, une couche 3 en $Al_x Ga_{1-x}$ As de type n, deux régions 4 de source et 5 de drain; une couche 13 d'isolant tel que de la silice est déposée sur la couche de $Al_x Ga_{1-x}$ As et sous la métallisation 14 de prise de contact de grille. Les deux régions de source 4 et de drain 5 sont dopées $n^+$ et pénètrent dans la couche en GaAs dopé p jusqu'à la zone d'inversion de charge. Les procédés de réalisation de ces régions de source et de drain sont connus, ainsi que les procédés de dépôt d'isolant sur $Al_x Ga_{1-x}$ As.

Le deuxième exemple de réalisation de transistor FET à hétérojonction anisotype p-n est représenté sur la figure 7. Il comporte comme précédemment, un substrat semi-isolant 1, une couche 2 en GaAs de type p faible dopé, une couche 3 en n-$Al_xGa_{1-x}As$, une couche 13 d'oxyde isolant. Cependant, les source et drain sont obtenus directement par les métallisations 15 de source et 16 de drain sur les flancs de la partie proéminente constituée par l'empilement des couches de GaAs et $Al_xGa_{1-x}As$, appelé mésa. Sans autres précautions, ces métallisations recouvriraient à la fois les flancs des couches de GaAs et de $Al_x Ga_{1-x}$ As. Comme elles sont du type servant de prise de contact ohmique sur GaAs de type n, avec un taux de dopage de l'ordre de $10^{17}At$ cm³, elles ne forment des contacts ohmiques qu'-avec la couche d'inversion qui se trouve dans la couche 2, à proximité de l'hétérojonction. Pour éviter qu'elles ne créent un courant de fuite entre source et drain à travers la couche de grille 3 de $Al_x Ga_{1-x}$ As, cette dernière est isolée des métallisations par des sillons d'oxydes 17 et 18 d'épaisseur de quelques dizaines à quelques centaines d'angstroëms qui entourent la couche 3 de $Al_x Ga_{1-x}$ As.

La formation de la couche d'inversion dans une hétérojonction anisotype se passe de façon analogue à celle de la couche d'inversion dans les MOS à inversion. En outre, l'adjonction d'une couche d'isolant sur la couche de $Al_x Ga_{1-x}$ As rend les structures représentées sur les figures 6 et 7 très proches des structures MIS ou MOS. Par contre, l'interposition d'une couche de $Al_x Ga_{1-x}$ As de type n entre la couche de GaAs de type p et la couche d'isolant confère aux structures à hétérojonction anisotype la propriété de forte mobilité d'électrons dans la couche d'inversion, alors que la mobilité des électrons dans une couche à inversion d'un MOS est faible. Il s'ensuit que les transistors FET à hétérojonction anisotype p-n ont des fréquences de coupure plus élevées que les transistors MOS.

Les applications mettant en jeu la couche d'inversion d'une hétérojonction anisotype p-n ne se limitent pas seulement aux transistors à effet de champ. D'une manière analogue aux MOS, la structure d'hétérojonction à couche d'inversion peut-être aussi utilisée dans les dispositifs à transfert de charges, connus sous le terme CCD ou Charge Coupled Devices, qui sont constitués par une suite de capacités MOS, dont chacune est formée par une jonction entre une grille et un substrat.

## Revendications

1. Transistor à effet de champ pour hautes fréquences, du type normalement bloqué, à résistance de sortie élévée, comportant, supportées par un substrat semi-isolant (1), une région de commande constituée d'une couche active et d'une couche de grille formant une hétérojonction, la couche de grille étant pourvue d'une métallisation (14) formant contact ohmique, ce dispositif étant caractérisé en ce que l'hétérojonction est formée d'une couche active (2) en GaAs faiblement dopé de type p et d'une couche (13) faisant fonction de grille de commande en $Al_x Ga_{1-x}$ As dopé de type n, une zone d'inversion de charge (12) à grande mobilité électronique, se formant dans la couche active (2) de type p à proximité de l'hétérojonction lorsqu'une tension positive est appliquée sur la grille (3) en $Al_x Ga_{1-x}$ As et

n'existant pas en l'absence de cette polarisation.

2. Transistor à effet de champ caractérisé en ce que le dispositif semiconducteur selon la revendication 1 est tel que les régions de source (4) et de drain (5) sont réalisées en n⁺ GaAs dans le substrat (1) en GaAs semi-isolant, ces deux régions pénétrant dans la couche active (2) jusqu'à la zone d'inversion de charge (12).

3. Transistor à effet de champ caractérisé en ce que le dispositif semiconducteur selon la revendication 1 est tel qui les régions de source (15) et de drain (16) sont réalisées par des métallisations supportées par le substrat (1) et recouvrant les flancs de la couche active (2).

4. Transistor à effet de champ selon l'une des revendications 2 ou 3 caractérisé en ce que, en vue de diminuer le courant de fuite de la grille, une couche d'isolant (13) est disposée entre la grille (3) en n $Al_x Ga_{1-x}$ As et la métallisation (14) de grille.

## Patentansprüche

1. Normalerweise gesperrter Hochfrequenz-Feldeffekt-Transistor mit hohem Ausgangswiderstand, mit einer auf einer halbisolierenden Trägerschicht (1) angeordneten Steuerschicht, die von einer aus einer Aktivschicht und einer Gitterschicht bestehenden Heterogenverbindung gebildet wird, wobei die Gitterschicht mit einem ohmschen Kontakt bildenden Metallbelag versehen ist, dadurch gekennzeichnet, dass die Heterogenverbindung besteht aus einer schwach p-dotierten GaAs-Aktivschicht (2) und einer als Steuergitter wirkenden n-dotierten $Al_x Ga_{1-x}$As-Schicht, wobei sich in Nähe der Heterogenverbindung in der Aktivschicht (2) vom p-Typ eine Ladungsumkehrzone (12) mit hoher elektronischer Beweglichkeit ausbildet, wenn eine positive Spannung an das $Al_x Ga_{1-x}$As-Gitter (3) angelegt wird, während diese Umkehrzone bei Abwesenheit dieser Polarisierung nicht vorliegt.

2. Feldeffekttransistor, dadurch gekennzeichnet, dass die Halbleitervorrichtung nach Anspruch 1 derart ausgebildet ist, dass zie Zufluss- und Abflusszonen (4 bzw. 5) in der halbisolierended GaAs-Trägerschicht (1) durch n⁺GaAs gebildet werden, wobei diese beiden Zonen bis zur Ladungsumkehrzone (12) in die Aktivschicht (2) eindringen.

3. Feldeffekttransistor, dadurch gekennzeichnet, dass die Halbleitervorrichtung nach Anspruch 1 derart ausgebildet ist, dass die Zufluss- und Abflusszonen (15 bzw. 16) durch von der Trägerschicht (1) getragene und die Flanken der Aktivschicht bedeckende Metallbeläge gebildet sind.

4. Feldeffekttransistor nach einem der Ansprüche 2 und 3, dadurch gekennzeichnet, dass zwecks Verminderung des Gitterleckstroms Zwischen dem $Al_x Ga_{1-x}$As-n-Gitter (3) und dem Gittermetallbelag (14) eine Isolierschicht (13) angeordnet ist.

**Claims**

1. A normally blocked high-frequency field-effect transistor having an elevated output resistance, and comprising, supported by a semi-isolating substrate (1), a control region constituted by an active layer and a grid layer forming a heterojunction, said device being characterized in that the heterojunction is formed by a slightly p-doped gaAs active layer (2) and a n-type doped $Al_xGa_{1-x}As$ layer acting as a grid, a load-inverting zone (12) with high electronic mobility being formed in the p-type active layer (2) near said heterojunction when a positive voltage is applied to the $Al_xGa_{1-x}As$ grid (3), whereas said inverting zone does not exist in the absence of such polarization.

2. A field-effect transistor, characterized in that the semiconductor device according to claim 1 is constructed in such a manner that the source and drain regions (4 and 5) are in the form of $n^+GaAs$ in the semi-isolating GaAs substrate (1), said two regions penetrating said active layer (2) up to said load inverting zone (12).

3. A field-effect transistor, characterized in that the semiconductor device according to claim 1 is constructed in such a manner that the source and drain regions (15 and 16) are formed by metallization layers supported by the substrate and covering the flanks of the active layer (2).

4. A field-effect transistor according to any one of claims 2 and 3, characterized in that, with a view to decreasing the leak current of the grid, an isolating layer (3) is provided between the n-type $Al_xGa_{1-x}As$ grid and the metallization layer (14) of the grid.

FIG.1

FIG.2

FIG.3

1

FIG.4

$V_1 = V_2$

FIG.5

$V_1 < V_2$

FIG. 6

FIG.7